# EUROPEAN PATENT APPLICATION

(11) **EP 4 851 765 A1**
(43) Date of publication of application: **09.12.2026**
(21) Application number: 26179616.3
(22) Date of filing: 19.05.2026
(51) Int. Cl.: G06F 3/041, H10K 59/40, H10K 59/80, G06F 3/044

(54) **DISPLAY DEVICE AND ELECTRONIC DEVICE INCLUDING THE SAME**

(30) Priority: 02.06.2025 KR 20250071793
(71) Applicant: Samsung Display Co., Ltd., Yongin-si, Gyeonggi-do 17113 (KR)
(72) Inventor: KIM, Jaeik, Yongin-si (KR); LEE, Samin, Yongin-si (KR); MOON, Youngmin, Yongin-si (KR); KIM, Arong, Yongin-si (KR)
(74) Representative: Marks & Clerk LLP

(57) **Abstract**

The present disclosure provides a display device and an electronic device including the same. In an embodiment, the display device includes: a substrate; a driving element layer on the substrate and comprising a driving element configured to drive a display panel, a first electrode of a pixel, and a pixel defining layer configured to define an opening on a portion of the first electrode; a light-emitting layer in the opening; a second electrode on the light-emitting layer and the pixel defining layer; an auxiliary conductive layer on the second electrode; an auxiliary electrode on the auxiliary conductive layer; and an encapsulation layer on the auxiliary electrode.

## Description

### TECHINICAL FIELD

The present disclosure relates to a display device and an electronic device including the same.

### BACKGROUND

With the development of multimedia, interest in display devices is increasing. For example, interest in display devices such as a liquid crystal display (LCD), an organic light-emitting display (OLED), or the like is growing. Among the display devices, the organic light-emitting display may include a light-emitting device that can emit light by itself, thereby displaying an image without a backlight unit.

The display device may include a touch panel. As the display device achieves higher performance (e.g., high resolution, high refresh rate) and becomes slimmer, interference between a display panel and the touch panel may occur. For example, noise generated during high-speed driving of the display panel may be introduced into the touch panel (e.g., the receiving end of the touch panel), and transmission noise from the touch panel may be introduced into the display panel (e.g., a transistor for driving pixels). Therefore, a method for preventing interference (e.g., noise introduction) between the display panel and the touch panel is required.

### SUMMARY

According to an aspect of the present disclosure, there is provided a display device with an improved drop in internal resistance (IR), and an electronic device including the display device.

According to another aspect of the present disclosure, there is provided a display device with improved light extraction efficiency, and an electronic device including the display device.

According to other aspect of the present disclosure, there is provided a display device with improved encapsulation performance, and an electronic device including the display device.

According to embodiments of the present disclosure, a display device includes: a substrate; a driving element layer on the substrate and including a driving element configured to drive a display panel, a first electrode of a pixel, and a pixel defining layer configured to define an opening on a portion of the first electrode; a light-emitting layer in the opening; a second electrode on the light-emitting layer and the pixel defining layer; an auxiliary conductive layer on the second electrode; an auxiliary electrode on the auxiliary conductive layer; and an encapsulation layer on the auxiliary electrode.

According to an embodiment, the display panel may include a display area in which an image is displayed and a non-display area in which no image is displayed and which is located at an outer periphery of the display panel. The auxiliary electrode and the auxiliary conductive layer may extend to the non-display area.

According to an embodiment, the auxiliary electrode may extend up to a protective area in the non-display area.

According to an embodiment, the auxiliary electrode may extend beyond a protective area in the non-display area and one end of the auxiliary electrode may be positioned between the auxiliary conductive layer and the protective area in a first direction and a second direction crossing to the first direction.

According to an embodiment, the auxiliary electrode may extend beyond a protective area in the non-display area and one end of the auxiliary electrode may be positioned between the encapsulation layer and the auxiliary conductive layer in a first direction and a second direction crossing to the first direction.

According to an embodiment, the auxiliary electrode may completely cover the auxiliary conductive layer. One end of the auxiliary electrode may be exposed to the outside.

According to an embodiment, at least one of the auxiliary conductive layer and the auxiliary electrode may include a plurality of layers.

According to an embodiment, the auxiliary conductive layer may be configured to improve protective characteristics. The auxiliary electrode may be configured to improve at least one of resistance characteristics, adhesion characteristics, and optical characteristics.

According to an embodiment, the display device may further include an auxiliary protective layer positioned between the auxiliary conductive layer and the encapsulation layer to assist in enhancing protective characteristics of the auxiliary conductive layer.

According to an embodiment, the auxiliary protective layer may be a multi-layer structure.

According to an embodiment, the auxiliary electrode may be in direct contact with the auxiliary conductive layer or may be electrically connected thereto through a contact hole in the auxiliary conductive layer.

According to an embodiment, the display device may further include an optical characteristic adjustment layer positioned between the second electrode and the auxiliary conductive layer.

According to an embodiment, the optical characteristic adjustment layer may include a capping layer or a lithium fluoride (LiF) layer.

According to an embodiment, the display device may further include a touch electrode on the encapsulation layer.

According to embodiments of the present disclosure, an electronic device includes: a display device; a memory configured to store data for operation of the display device; and one or more processors configured to execute the data stored in the memory to control the operation of the display device. The display device includes: a substrate; a driving element layer on the substrate and including a driving element configured to drive a display panel, a first electrode of a pixel, and a pixel defining layer configured to define an opening on a portion of the first electrode; a light-emitting layer in the opening; a second electrode on the light-emitting layer and the pixel defining layer; an auxiliary conductive layer on the second electrode; an auxiliary electrode on the auxiliary conductive layer; and an encapsulation layer on the auxiliary electrode.

According to an embodiment, the display panel may include a display area in which an image is displayed and a non-display area in which no image is displayed and which is located at an outer periphery of the display panel. The auxiliary electrode and the auxiliary conductive layer may extend to the non-display area.

According to an embodiment, the auxiliary electrode may extend up to a protective area in the non-display area.

According to an embodiment, the auxiliary electrode may extend beyond a protective area in the non-display area and one end of the auxiliary electrode may be positioned between the auxiliary conductive layer and the protective area in a first direction and a second direction crossing to the first direction.

According to an embodiment, the auxiliary electrode may extend beyond a protective area in the non-display area and one end of the auxiliary electrode may be positioned between the encapsulation layer and the auxiliary conductive layer in a first direction and a second direction crossing to the first direction.

According to an embodiment, the auxiliary electrode may completely cover the auxiliary conductive layer. One end of the auxiliary electrode may be exposed to the outside.

At least some of the above and other features of the invention are set out in the claims.

### BRIEF DESCRIPTION OF THE DRAWINGS

The above and other features and other advantages of the present disclosure will be more clearly understood from the following detailed description taken in conjunction with the accompanying drawings.
FIG. 1 is a view illustrating a display device according to an embodiment.
FIG. 2 is a plan view illustrating the display panel according to an embodiment.
FIG. 3A is a schematic cross-sectional view of the display device according to an embodiment.
FIG. 3B is a view illustrating the shape of an auxiliary electrode according to an embodiment.
FIG. 4A is a view illustrating an example of a cross-section taken along line A-A' in FIG. 2.
FIG. 4B is a view illustrating an example of the cross-section taken along line A-A' in FIG. 2.
FIG. 4C is a view illustrating an example of the cross-section taken along line A-A' in FIG. 2.
FIG. 4D is a view illustrating an example of the cross-section taken along line A-A' in FIG. 2.
FIG. 5 is a schematic cross-sectional view of a display device according to an embodiment.
FIG. 6 is a schematic cross-sectional view of a display device according to an embodiment.
FIG. 7 is a schematic cross-sectional view of a display device according to an embodiment.
FIG. 8 is a schematic cross-sectional view of a display device according to an embodiment.
FIG. 9 is a block diagram illustrating the configuration of an electronic device according to an embodiment.
FIG. 10 is a set of schematic views illustrating electronic devices according to various embodiments.

### DETAILED DESCRIPTION OF THE EMBODIMENTS

Hereinafter, various embodiments of the present disclosure will be described with reference to the accompanying drawings. Specific embodiments of the present disclosure will be illustrated in the drawings and described in the following detailed description related thereto, but it is not intended to limit the various embodiments of the present disclosure to a specific form. For example, it will be obvious to those skilled in the art to which the present disclosure pertains that the embodiments of the present disclosure may be variously modified.

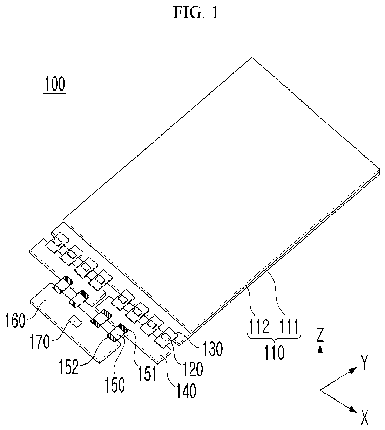

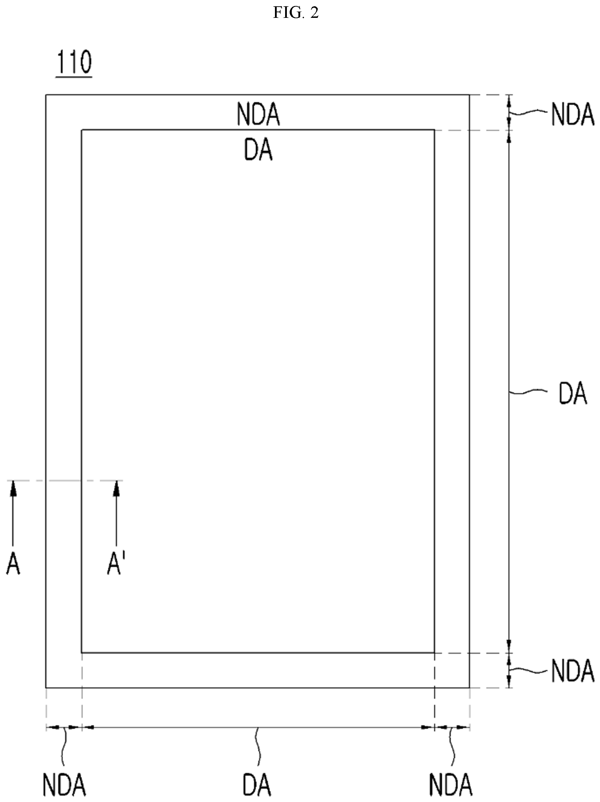

FIG. 1 is a view illustrating a display device 100 according to an embodiment, and FIG. 2 is a plan view illustrating a display panel 110 according to an embodiment.

Prior to the detailed description, the display device 100 according to an embodiment is a device for displaying images (e.g., still or moving images), and may include a plurality of pixels. The display device 100 according to an embodiment may be formed as rigid, curved, bent, or flexible (e.g., foldable, rollable, stretchable). The display device 100 may be used as a display screen for various products, including portable electronic devices such as mobile phones, smartphones, tablet PCs, laptops, smart watches, watch phones, mobile communication terminals, electronic notebooks, e-books, portable multimedia players (PMPs), navigation devices, and ultra-mobile PCs (UMPCs), as well as multimedia devices installed, embedded, or integrated in vehicles (e.g., vehicle displays, head-up displays), home appliances (e.g., televisions), monitors, billboards, and Internet of Things (IoT) devices.

Hereinafter, the terms "upper portion," "top," and "upper surface" refer to an upward direction, that is, the Z-axis direction, based on the display panel 110 of the display device 100, and the terms "lower portion," "bottom," and "lower surface" refer to a downward direction, that is, the direction opposite to the Z-axis direction, based on the display panel 110. In addition, the terms "upper side," "lower side," "left side," and "right side" refer to directions when the display panel 110 is viewed in a planar view. For example, the "upper side" refers to the Y-axis direction, the "lower side" refers to the direction opposite to the Y-axis direction, the "left side" refers to the direction opposite to the X-axis direction, and the "right side" refers to the X-axis direction.

Referring to FIGS. 1 and 2, the display device 100 according to an embodiment of the present disclosure may include the display panel 110, data drivers 120, flexible films 130, a source circuit board 140, connection members 150, a control circuit board 160, and a timing controller 170.

The display panel 110 may be formed in a rectangular shape. For example, the display panel 110 may have a rectangular shape with short sides in a first direction (X-axis direction) and long sides in a second direction (Y-axis direction). The planar shape of the display panel 110 is not limited to a rectangle, and may be formed in other polygonal, circular or oval shapes. The display panel 110 may have corners formed at right angles or rounded with a predetermined curvature. In addition, although FIGS. 1 and 2 illustrate that the display panel 110 is formed flat, it is not limited thereto. For example, the display panel 110 may include a curved portion bent at a predetermined curvature. As an example, the display panel 110 may be flexible.

According to an embodiment, the display panel 110 may include a first substrate 111 and a second substrate 112. The second substrate 112 may be disposed to face a first surface of the first substrate 111. The first substrate 111 and the second substrate 112 may be formed as a rigid or flexible substrate. The first substrate 111 may be made of glass or plastic, but is not limited thereto. The second substrate 112 may be made of glass, plastic, an encapsulation film, or a barrier film. In an embodiment, the second substrate 112 may be omitted.

According to an embodiment, the display panel 110 may be an organic light-emitting display panel using an organic light-emitting diode, a quantum dot light-emitting display panel which includes a quantum dot light-emitting layer, an inorganic light-emitting display panel including an inorganic semiconductor, and an ultra-small light-emitting display panel using a micro light-emitting diode (LED). Hereinafter, for convenience of description, a case in which the display panel 110 is an organic light-emitting display panel will be described as an example.

The display panel 110 may include a display area DA and a non-display area NDA, as shown in FIG. 2. The display area DA is an area in which images (e.g., still or moving images) may be displayed, and the non-display area NDA is an area in which no image is displayed. The display area DA may also be referred to as an active area, and the non-display area NDA may also be referred to as a non-active area.

The display area DA may include a plurality of pixels (or light-emitting devices). The plurality of pixels may be arranged in a matrix form. Each pixel may emit light with a luminance corresponding to a driving current supplied by a pixel circuit. According to an embodiment, each pixel may include a plurality of sub-pixels. The plurality of sub-pixels may include, but are not limited to, a red pixel emitting red light, a green pixel emitting green light, and a blue pixel emitting blue light. According to some embodiments, at least some of the plurality of pixels may include only some of the red, green or blue pixels. According to some embodiments, at least some of the plurality of pixels may include a plurality of at least one type of the red, green and blue pixels.

Although not shown in the drawings, the display area DA may include a plurality of pixel circuits (e.g., transistors, capacitors) that individually control the driving (e.g., light emission) of a plurality of pixels. The display area DA may also include, although not shown in the drawings, scan signal lines, data lines, and driving voltage lines connected to the pixels, and power electrodes connecting each pixel with the driving voltage lines. The scan signal lines may be arranged in the first direction (X-axis direction) within the display area DA, but are not limited thereto. The data lines may be arranged in the second direction (Y-axis direction) intersecting (e.g., vertically intersecting) the first direction (X-axis direction) within the display area DA, but are not limited thereto. The driving voltage lines may be arranged in the second direction (Y-axis direction) within the display area DA, but are not limited thereto. The power electrodes may include a positive electrode (e.g., an anode electrode) for supplying positive power and a common electrode (e.g., a cathode electrode) for supplying common power (e.g., ground power). The common electrode may be connected to all of the plurality of pixels.

The non-display area NDA may be defined as an area extending from the outer boundary of the display area DA to the edge of the display panel 110. For example, the non-display area NDA may, without limitation, surround the display area DA and be positioned at the outer periphery of the display panel 110. The non-display area NDA may include, but is not limited to, a scan driver. The scan driver may receive scan control signals (e.g., a plurality of clock signals, a gate-on voltage, a gate-off voltage, etc.) from the timing controller 170 through a plurality of scan control lines. The scan driver may generate scan signals based on the scan control signals, and provide the generated scan signals to the pixel circuit through the scan signal lines.

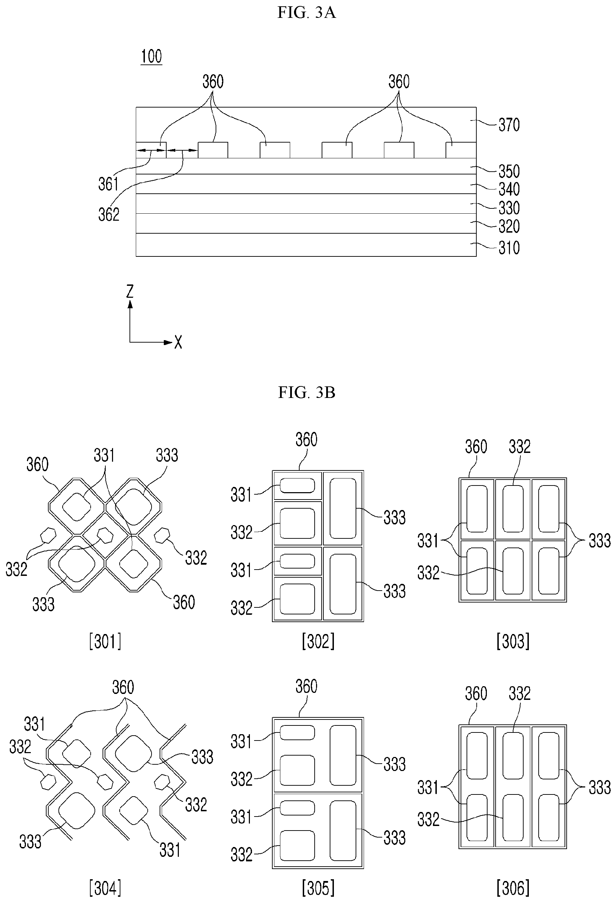

According to an embodiment, the display panel 110 has an auxiliary conductive layer and an auxiliary electrode positioned on the upper portion of the common electrode. Accordingly, the display panel 110 may exhibit improved internal resistance (IR), light extraction efficiency, and/or encapsulation performance. In this regard, detailed descriptions will be provided below with reference to FIGS. 3A to 8.

The flexible film 130 may have one side attached to the first surface of the first substrate 111 of the display panel 110, and another side attached to one surface of the source circuit board 140. For example, since the size of the second substrate 112 is smaller than the size of the first substrate 111, one side of the first substrate 111 may be exposed without being covered by the second substrate 112. The flexible film 130 may be attached to the exposed side of the first substrate 111 that is not covered by the second substrate 112.

The flexible film 130 may be attached to the first surface of the first substrate 111 and one surface of the source circuit board 140 using an anisotropic conductive film, but is not limited thereto.

According to an embodiment, the flexible film 130 may be a flexible film such as a tape carrier package or a chip on film (COF). The flexible film 130 may be bent toward a lower portion of the first substrate 111. When the flexible films 130 are bent toward the lower portion of the first substrate 111, the source circuit board 140, the connection members 150, and the control circuit board 160 may be disposed on a lower surface of the display panel 110. Although FIG. 1 illustrates an example in which eight flexible films 130 are attached to the first substrate 111 of the display panel 110, this is merely an example and does not limit the present disclosure. For example, one or more flexible films 130 may be attached to the first substrate 111 of the display panel 110.

The data driver 120 may be disposed on one surface of the flexible film 130. The data driver 120 may be formed as an integrated circuit (IC). The data driver 120 may convert digital video data (DATA) into analog data voltages based on a data control signal from the timing controller 170 and supply the voltages to a data line of the display panel 110 through the flexible film 130.

The source circuit board 140 may be connected to the control circuit board 160 through the connection member 150. The source circuit board 140 may include a first connector 151 to which one side of the connection member 150 is connected (e.g., inserted). The source circuit board 140 may be a flexible printed circuit board (FPCB) or a printed circuit board (PCB).

The connection member 150 may connect the source circuit board 140 and the control circuit board 160. The connection member 150 may be a flexible cable, but is not limited thereto.

The control circuit board 160 may be connected to the source circuit board 140 through the connection member 150. The control circuit board 160 may include a second connector 152 to which another side of the connection member 150 is connected (e.g., inserted). The control circuit board 160 may be a flexible printed circuit board or a printed circuit board.

Although FIG. 1 illustrates an example in which the source circuit board 140 and the control circuit board 160 are connected by four connection members 150, this is merely an example and does not limit the present disclosure. For example, the source circuit board 140 and the control circuit board 160 may be connected by one or more connection members 150. In addition, although FIG. 1 illustrates an example including two source circuit boards 140, this is also merely an example and does not limit the present disclosure. For example, the display device 100 may include one or more source circuit boards 140. According to some embodiments, the source circuit board 140 may be omitted. If the source circuit board 140 is omitted, the connection member 150, the first connector 151 and the second connector 152 may also be omitted, and the flexible film 130 may be directly connected to the control circuit board 160.

The timing controller 170 may be disposed on one side of the control circuit board 160. The timing controller 170 may be formed as an integrated circuit.

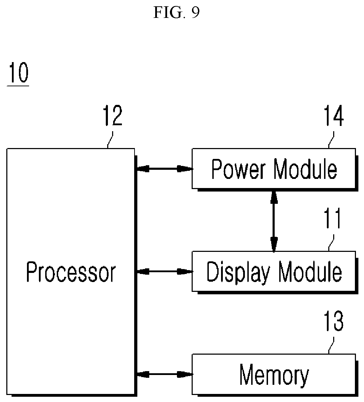

According to an embodiment, the timing controller 170 may receive digital video data and timing signals from a processor (such as a central processing unit (CPU), an application processor (AP), or a graphic processing unit (GPU)) of a main circuit board of an electronic device (e.g., an electronic device 10 of FIG. 9). The timing controller 170 may generate a source control signal (e.g., a clock signal) for controlling timing of the data driver 120 and a scan control signal for controlling timing of the scan driver based on the timing signals. The timing controller 170 may output a scan control signal to the scan driver, and transmit the digital video data (DATA) along with the source control signal to the data driver 120. According to an embodiment, the timing controller 170 may include a clock generation circuit.

According to an embodiment, the display device 100 may further include a power module (e.g., a power module 14 of FIG. 9) that supplies power for driving each pixel. Some configurations of the display device 100 and the power module may be incorporated into an electronic device.

FIG. 3A is a schematic cross-sectional view of the display device 100 according to an embodiment, and FIG. 3B is a view illustrating the shape of an auxiliary electrode 360 according to an embodiment.

Referring to FIGS. 3A and 3B, the display device 100 according to an embodiment includes a substrate 310, a driving element layer 320, a light-emitting layer 330, a common electrode 340, an auxiliary conductive layer 350, the auxiliary electrode 360, and an encapsulation layer 370.

The substrate 310 may be made of glass or plastic, but is not necessarily limited thereto. The substrate 310 may be made of a transparent material or an opaque material. For example, when light emitted from the light-emitting layer 330 is emitted upward, the substrate 310 may be formed of a transparent material or an opaque material. In an embodiment, when light emitted from the light-emitting layer 330 is emitted downward, the substrate 310 may be formed of a transparent material. The substrate 310 may correspond to the first substrate 111 of FIG. 1.

The driving element layer 320 is formed on the substrate 310. The driving element layer 320 may include circuit elements such as various signal lines, thin film transistors, and capacitors for each pixel. The circuit elements may also be regarded as driving elements for driving the display panel 110. The signal lines may include gate lines, data lines, power lines, and reference lines, and the thin film transistors may include switching thin film transistors, driving thin film transistors, and sensing thin film transistors. Here, the various signal lines, thin film transistors, and capacitors included in the driving element layer 320 have configurations known to those skilled in the art, and therefore will not be described in detail.

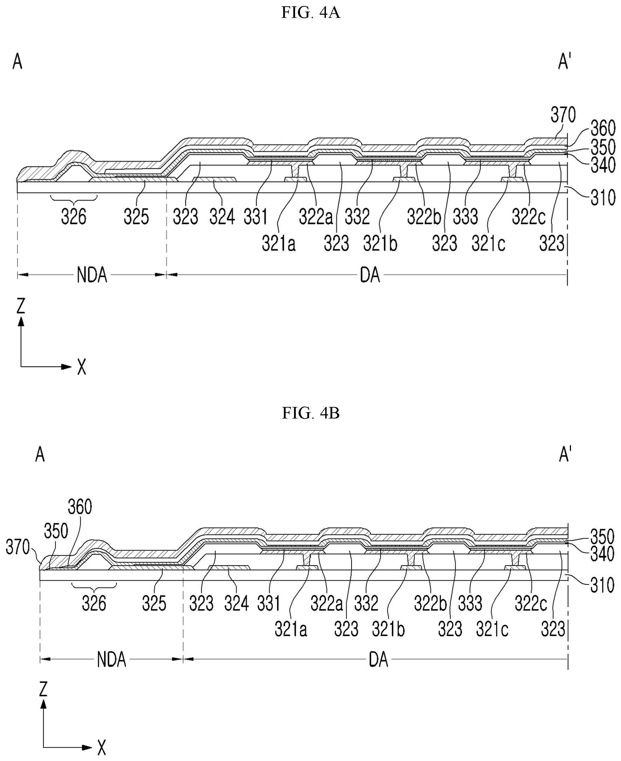

The driving element layer 320 may further include a positive electrode (also referred to as a first electrode) (e.g., an anode electrode) and a pixel defining layer. The positive electrode may be formed in a patterned manner for each pixel. The pixel defining layer may define an opening (also referred to as a light-emitting area) which extends to and through which a portion of the positive electrode is exposed. Detailed descriptions of the positive electrode and the pixel defining layer will be provided below with reference to FIGS. 4A to 4D.

The light-emitting layer 330 is formed in the opening defined by the pixel defining layer. The light-emitting layer 330 may include a plurality of pixels. The pixel refers to a minimum unit that forms an image. The pixel may include a plurality of sub-pixels to express various colors and grayscale levels. For example, as shown in FIG. 3B, each pixel may include a first sub-pixel 331 that emits red light, a second sub-pixel 332 that emits green light, and a third sub-pixel 333 that emits blue light. According to an embodiment, at least one of the first sub-pixel 331, the second sub-pixel 332 and the third sub-pixel 333 included in each pixel may be present in plural. The number of the first sub-pixel 331, the second sub-pixel 332 and the third sub-pixel 333 included in each pixel may be the same or different. According to some embodiments, the light-emitting layer 330 may also include a sub-pixel that emits white light. In this case, a color filter may be additionally positioned in the path of light emitted from the light-emitting layer 330.

The above-described light-emitting layer 330 may include at least one organic layer selected from a hole injection layer, a hole transporting layer, an organic light-emitting layer, an electron transporting layer, and an electron injection layer.

The common electrode 340 (also referred to as a second electrode) (e.g., a cathode electrode) is formed on the light-emitting layer 330. The common electrode 340 (e.g., the cathode electrode) may be individually connected to a plurality of pixels. In an embodiment, the common electrode 340 may be connected to pixels located in the same row or all pixels, and may apply a common voltage (e.g., ground voltage) to the connected pixels. The common electrode 340 is formed not only on the light-emitting layer 330 but also on the pixel defining layer, and may be formed across a plurality of light-emitting areas.

The auxiliary conductive layer 350 is formed on the common electrode 340. The auxiliary conductive layer 350 may be in contact with (electrically connected to) the common electrode 340. The auxiliary conductive layer 350 may be formed of a transparent conductive film (also referred to as a transparent electrode) (e.g., transparent conductive oxide: TCO). The auxiliary conductive layer 350 may cover the entire display area DA. According to some embodiments, the auxiliary conductive layer 350 may extend to an outer region of the display panel (e.g., the non-display area NDA). In this regard, detailed descriptions will be provided below with reference to FIGS. 4A to 4D.

The auxiliary conductive layer 350 may provide protective characteristics (e.g., encapsulation performance) to the device during subsequent processes (e.g., patterning of the auxiliary electrode 360, encapsulation process, module process, etc.). For example, the auxiliary conductive layer 350 may have a water vapor transmission rate (WVTR) less than a designated first reference value (e.g., 1×10⁻² g/m²·day) (or less) and/or an oxygen transmission rate (OTR) less than a designated second reference value (e.g., 1×10⁻² cc/m²·day) (or less).

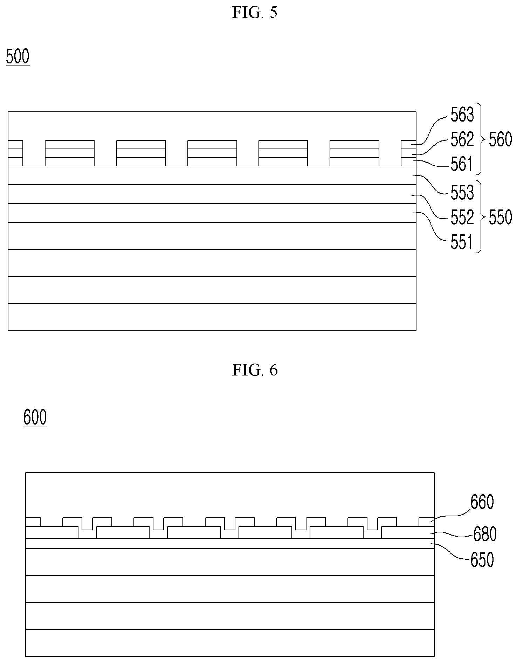

According to some embodiments, the auxiliary conductive layer 350 may include a plurality of layers. For example, the auxiliary conductive layer 350 may be formed by combining (e.g., laminating) multiple auxiliary conductive layers having different properties to prevent moisture (e.g., water vapor) and/or oxygen permeation, in order to improve protective characteristics (e.g., encapsulation performance). In this regard, detailed descriptions will be provided below with reference to FIGS. 5 to 8. According to some embodiments, the auxiliary conductive layer 350 may include a non-conductive layer to enhance protective characteristics (e.g., encapsulation performance). In this case, the auxiliary conductive layer 350 may include a contact hole for either direct physical contact or electrical connection to the auxiliary electrode 360.

The auxiliary electrode 360 is located on the auxiliary conductive layer 350. For example, the auxiliary electrode 360 may be in direct contact with the auxiliary conductive layer 350. The auxiliary electrode 360 may be formed to overlap with the opening (light-emitting area) defined by the pixel defining layer. According to some embodiments, the auxiliary electrode 360 is patterned so as not to overlap with the opening (light-emitting area) defined by the pixel defining layer. In this case, since the auxiliary electrode 360 is not positioned above the opening (light-emitting area), the image quality may be improved (e.g., degradation in image quality due to the auxiliary electrode 360 may be prevented). The auxiliary electrode 360 may further improve protective characteristics (e.g., encapsulation performance). For example, the auxiliary electrode 360 may extend to the outer region of the display panel (e.g., the non-display area NDA). In this regard, detailed descriptions will be provided below with reference to FIGS. 4A to 4D.

The auxiliary electrode 360 may further improve the resistance characteristics (or conductive characteristics) of the common electrode 340 (e.g., achieve low resistance characteristics). For example, the auxiliary electrode 360 may overcome the limitations of a transparent conductive film that cannot sufficiently reduce the resistance characteristics (or conductive characteristics). The auxiliary electrode 360 may be formed of metal. The auxiliary electrode 360 may be patterned to be positioned between the sub-pixels 331, 332 and 333, as shown in the drawings indicated by reference numerals 301, 302, 303, 304, 305 and 306 in FIG. 3B. The patterning form of the auxiliary electrode 360 shown in FIG. 3B is merely an example and does not limit the present disclosure. The auxiliary electrode 360 may be formed as a mesh or a solid line. The auxiliary electrode 360 may have an adjustable open rate to prevent degradation in optical characteristics. The open rate may be controlled by adjusting a width 361 and/or a distance 362 of the mesh or solid line, see FIG. 3A. For example, the auxiliary electrode 360 may have an open rate of 5% to 99%. The auxiliary electrode 360 may have a thickness equal to or greater than a designated thickness (e.g., 100 angstrom (Å)), but is not limited thereto.

In some embodiments, the auxiliary electrode 360 may include a plurality of layers to improve conductivity and optical characteristics. For example, the auxiliary electrode 360 may include at least one of a conductor (e.g., a metal layer, a transparent electrode (TCO) layer), an organic layer, and an inorganic layer. In some embodiments, the auxiliary electrode 360 may include a plurality of layers to improve adhesion characteristics and external light reflection characteristics. In this regard, detailed descriptions will be provided below with reference to FIGS. 5 to 8.

The encapsulation layer 370 is formed on the auxiliary electrode 360. The encapsulation layer 370 may prevent moisture and/or oxygen from penetrating into the light-emitting layer 330. The encapsulation layer 370 may be formed of a structure in which an inorganic insulating material, or alternating layers of inorganic and organic insulating materials, are stacked, but is not limited thereto. The encapsulation layer 370 may extend to the outer periphery of the display panel (e.g., the non-display area NDA).

According to an embodiment, the display device may further include an optical characteristic adjustment layer positioned between the common electrode 340 and the auxiliary conductive layer 350. The optical characteristic adjustment layer may include a capping layer (CPL) or a lithium fluoride (LiF) layer.

FIG. 4A is a view illustrating an example of a cross-section taken along line A-A' in FIG. 2.

Referring to FIG. 4A, a display device according to an embodiment includes a substrate 310, a driving element layer 320 (see FIG. 3A), a light-emitting layer 330 (see FIG. 3A), a common electrode 340, an auxiliary conductive layer 350, an auxiliary electrode 360, and an encapsulation layer 370.

The substrate 310 has the driving element layer 320 and the light-emitting layer 330 formed on its upper surface. The driving element layer 320 may include a first terminal 321a, a first positive electrode 322a, a second terminal 321b, a second positive electrode 322b, a third terminal 321c, a third positive electrode 322c, and a pixel defining layer 323. The driving element layer 320 may further include a power terminal 324 for supplying power and a common terminal 325.

The light-emitting layer 330 may include a first sub-pixel (or a first light-emitting layer) 331, a second sub-pixel (or a second light-emitting layer) 332, and a third sub-pixel (or a third light-emitting layer) 333. Openings (or light-emitting areas) of the first sub-pixel 331 to the third sub-pixel 333 may be defined by the pixel defining layer 323.

The substrate 310 may include a display area DA and a non-display area NDA. In the display area DA of the substrate 310, the first terminal 321a, the first positive electrode 322a, the first sub-pixel (or a first light-emitting layer) 331, the second terminal 321b, the second positive electrode 322b, the second sub-pixel (or a second light-emitting layer) 332, the third terminal 321c, the third positive electrode 322c, the third sub-pixel (or a third light-emitting layer) 333, the pixel defining layer 323, and the power terminal 324 may be formed. In the non-display area NDA of the substrate 310, the common terminal 325 may be formed.

As shown in FIG. 4A, the common electrode 340 may be patterned to be in contact with the pixel defining layer 323 in the display area DA and a portion of the common terminal 325 in the non-display area NDA. According to some embodiments, the common electrode 340 may be formed to be in contact with the pixel defining layer 323, the first to third sub-pixels 331, 332 and 333 in the display area DA, and a portion of the common terminal 325 in the non-display area NDA.

The auxiliary conductive layer 350 may be formed to extend longer than the common electrode 340 in the X-axis direction (e.g., the left direction in FIG. 4A). For example, the auxiliary conductive layer 350 may be formed to extend between a protective area 326 and one end of the substrate 310 (e.g., the left end in FIG. 4A) in the non-display area NDA.

The non-display area NDA may include the protective area 326. The protective area 326 may be formed to protrude from the upper portion of the substrate 310 in the Z-axis direction, using the same or a different material from the pixel defining layer 323. By protruding in the Z-axis direction, the protective area 326 may prevent moisture or oxygen from permeating from the non-display area NDA to the display area DA in the X-axis direction. FIG. 4A illustrates an example in which the non-display area NDA includes one protective area 326, but the non-display area NDA may include a plurality of protective areas 326.

The auxiliary electrode 360 may be formed to have a similar length to that of the common electrode 340 in the X-axis direction. For example, the auxiliary electrode 360 may be formed to extend up to the protective area 326 of the non-display area NDA. The encapsulation layer 370 may be formed to extend up to the outermost portion of the substrate 310.

FIG. 4B is a view illustrating an example of the cross-section taken along line A-A' in FIG. 2.

Referring to FIG. 4B, a display panel according to an embodiment may be formed such that an auxiliary electrode 360 extends beyond the protective area 326. For example, the auxiliary electrode 360 may extend to cover the protective area 326. The left end of the auxiliary electrode 360 may be positioned between the left end of the auxiliary conductive layer 350 and the left end of the protective area 326 in the X-axis direction. In the outermost region of the substrate 310, the auxiliary conductive layer 350 and the encapsulation layer 370 may be stacked (in contact) in the Z-axis direction, and in the region where the auxiliary electrode 360 extends, the auxiliary conductive layer 350, the auxiliary electrode 360, and the encapsulation layer 370 may be stacked in the Z-axis direction.

The additional extension of the auxiliary electrode 360 may improve protective characteristics (encapsulation performance). For example, as the auxiliary electrode 360 extends to cover the protective area 326, the protective characteristics (encapsulation performance) of the protective area 326 of the substrate 310 may be improved (e.g., enhanced). In other words, as the inorganic film bonding area where the auxiliary electrode 360 and the encapsulation layer 370 are bonded is further extended (or expanded) outward of the substrate 310 than in the embodiment of FIG. 4A, the protective characteristics may be improved. The auxiliary electrode 360 positioned in the non-display area NDA may not be patterned. The auxiliary electrode 360 may be formed using a shadow mask. In this case, the thickness of one end of the auxiliary electrode 360 (e.g., the left end in FIG. 4B) may be relatively small.

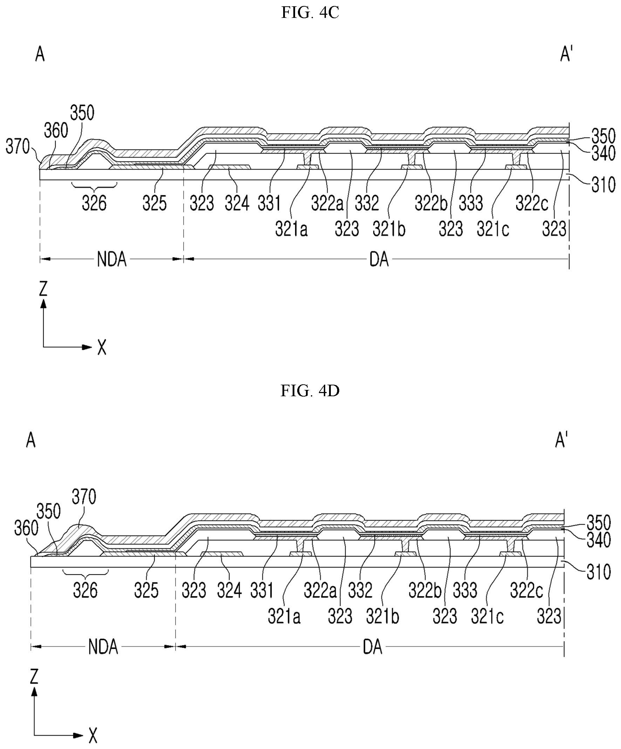

FIG. 4C is a view illustrating an example of the cross-section taken along line A-A' in FIG. 2.

Referring to FIG. 4C, a display panel according to an embodiment may have an auxiliary electrode 360 extending farther outward on the substrate 310 than the auxiliary conductive layer 350. For example, the auxiliary electrode 360 may extend to completely cover the auxiliary conductive layer 350. One end of the auxiliary electrode 360 (e.g., the left end in FIG. 4C) may be positioned between the encapsulation layer 370 and the auxiliary conductive layer 350 in the X-axis direction. In the outermost region of the substrate 310, the auxiliary electrode 360 and the encapsulation layer 370 may be stacked (in contact) in the Z-axis direction, and in the region where the auxiliary electrode 360 extends, the auxiliary conductive layer 350, the auxiliary electrode 360, and the encapsulation layer 370 may be stacked in the Z-axis direction.

As the auxiliary electrode 360 extends longer than the auxiliary conductive layer 350, the protective characteristics (encapsulation performance) of the end portion of the substrate 310 (e.g., the left end in FIG. 4C) may be improved (e.g., enhanced). For example, the protective characteristics may be improved through bonding of an inorganic film and/or a metal multi-layer.

FIG. 4D is a view illustrating an example of the cross-section taken along line A-A' in FIG. 2.

Referring to FIG. 4D, a display panel according to an embodiment may have an auxiliary electrode 360 that extends to the outermost edge of the substrate 310 (i.e., extending longer than the encapsulation layer 370). For example, the auxiliary electrode 360 may completely cover the auxiliary conductive layer 350 and be exposed to the outside. The auxiliary conductive layer 350, the auxiliary electrode 360, and the encapsulation layer 370 may be stacked in the Z-axis direction on the substrate 310. For example, the protective characteristics may be improved through bonding of an inorganic film and/or a metal multi-layer. As the auxiliary electrode 360 is exposed to the outside, an additional auxiliary electrode to which the auxiliary electrode 360 is connected may be further formed. In this case, the resistance characteristics of the common electrode 340 may be improved by further extending the auxiliary electrode.

FIG. 5 is a schematic cross-sectional view of a display device 500 according to an embodiment.

Referring to FIG. 5, the display device 500 according to an embodiment may be similar to the display device 100 shown in FIG. 3A. Therefore, detailed descriptions of similar configurations will be omitted. The display device 500 may have a multi-layer structure including an auxiliary conductive layer 550 and an auxiliary electrode 560. For example, the auxiliary conductive layer 550 may include, but is not limited to, a first auxiliary conductive layer 551, a second auxiliary conductive layer 552, and a third auxiliary conductive layer 553. The auxiliary conductive layer 550 may combine multiple auxiliary conductive layers having different properties to improve protective characteristics (e.g., encapsulation performance). The first auxiliary conductive layer 551, the second auxiliary conductive layer 552, and the third auxiliary conductive layer 553 may be formed through different processes.

The auxiliary electrode 560 may include a first auxiliary electrode 561, a second auxiliary electrode 562, and a third auxiliary electrode 563. The auxiliary electrode 560 may be formed in a multi-layer structure to improve conductivity and optical characteristics. The first auxiliary electrode 561, the second auxiliary electrode 562, and the third auxiliary electrode 563 may include at least one of a conductor (e.g., a metal electrode, a transparent electrode) for improving conductive characteristics (e.g., resistance characteristics), and an inorganic layer and an organic layer for improving optical characteristics. According to some embodiments, the first auxiliary electrode 561, the second auxiliary electrode 562, and the third auxiliary electrode 563 may include a plurality of layers to improve adhesion characteristics and external light reflection characteristics.

The auxiliary electrode (or auxiliary conductive layer) for improving conductive characteristics may be formed of Al, Ag, and/or Cu. The auxiliary electrode (or auxiliary conductive layer) for improving the adhesion properties may be formed of Ti, Ta, TaN, and/or TiN. The auxiliary electrode (or auxiliary conductive layer) for improving optical characteristics (e.g., reducing reflectivity) may be formed of TiN, Ti/TiN, Cr/CrN, Ta/TaN composite layers, W, AlOₓ combined with metal films, and/or Mo-based oxide films (or nitride films).

FIG. 6 is a schematic cross-sectional view of a display device 600 according to an embodiment.

Referring to FIG. 6, the display device 600 according to an embodiment may be similar to the display device 100 shown in FIG. 3A. Therefore, detailed descriptions of similar configurations will be omitted. The display device 600 may further include an auxiliary protective layer 680. The auxiliary protective layer 680 may assist in enhancing the protective characteristics of the auxiliary conductive layer 650. An upper surface of the auxiliary conductive layer 650 may be in contact (e.g., direct contact) with lower surfaces of an auxiliary electrode 660 and the auxiliary protective layer 680.

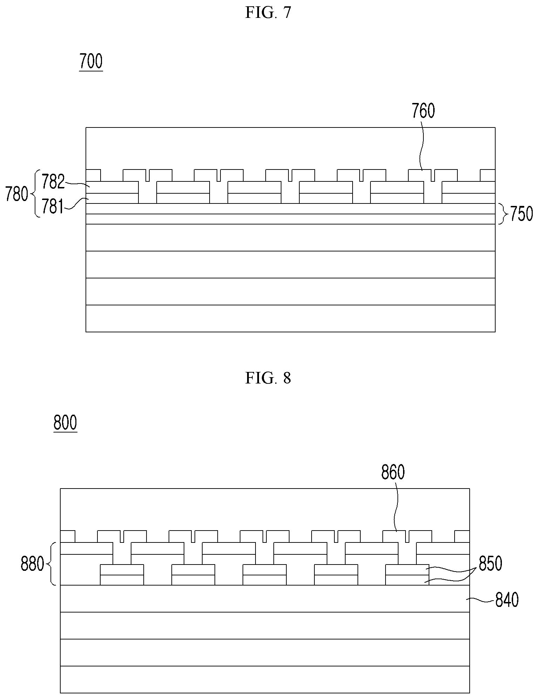

FIG. 7 is a schematic cross-sectional view of a display device 700 according to an embodiment.

Referring to FIG. 7, the display device 700 according to an embodiment may include an auxiliary protective layer 780 formed in a multi-layer structure. The auxiliary protective layer 780 may be formed by combining multiple auxiliary protective layers 781 and 782 having different properties to improve the protective characteristics. In addition, an auxiliary conductive layer 750 may also be formed in a multi-layer structure. According to some embodiments, the auxiliary conductive layer 750 may be formed as a single-layer. An upper surface of the auxiliary conductive layer 750 may be in contact (e.g., direct contact) with lower surfaces of an auxiliary electrode 760 and the auxiliary protective layer 780.

FIG. 8 is a schematic cross-sectional view of a display device 800 according to an embodiment.

Referring to FIG. 8, the display device 800 according to an embodiment may be similar to the display device 700 of FIG. 7. Therefore, detailed descriptions of similar configurations will be omitted. The display device 800 may have a patterned auxiliary conductive layer 850. At this time, a void created by the patterning of the auxiliary conductive layer 850 may be filled with an auxiliary protective layer 880.

An upper surface of a common electrode 840 may be in contact with the lower surface of the auxiliary protective layer 880 and the lower surface of the auxiliary conductive layer 850. The lower surface of the auxiliary conductive layer 850 may be in contact with the common electrode 840, a side surface and a portion of an upper surface may be in contact with the auxiliary protective layer 880, and another portion of the upper surface may be in contact with the lower surface of an auxiliary electrode 860.

Although the display device supporting the display function has been described above as an example, an embodiment of the present disclosure may also be applied to a display device that provides a touch function. For example, when the display device supports a touch function, a touch electrode may be additionally formed on the upper surface of the encapsulation layer. If the touch electrode is directly formed on the upper surface of the encapsulation layer, the distance between the driving circuit and the touch electrode of the display panel may be short, and mutual interference may occur between the driving signal and the touch signal of the display panel. However, in the display device according to an embodiment of the present disclosure, by forming an auxiliary conductive layer and an auxiliary electrode on the upper surface of the common electrode, mutual interference between the driving signal and the touch signal of the display panel may be prevented.

FIG. 9 is a block diagram illustrating the configuration of an electronic device 10 according to an embodiment.

Referring to FIG. 9, the electronic device 10 according to an embodiment may include a display module 11, a processor 12, a memory 13, and a power module 14.

The processor 12 may include one or more processors and may include at least one of a central processing unit (CPU), an application processor (AP), a graphic processing unit (GPU), a communication processor (CP), an image signal processor (ISP), and a controller.

The memory 13 may store data information necessary for an operation of the processor 12 or the display module 11. When the processor 12 executes an application stored in the memory 13, an image data signal and/or an input control signal may be transmitted to the display module 11, and then, the display module 11 may process the received signal and output image information through the display screen.

The power module 14 may include a power supply module such as a power adapter or a battery device, and a power conversion module that converts power supplied by the power supply module to generate power necessary for an operation of the electronic device 10.

At least one of the above-described configurations of the electronic device 10 may be included in the display device according to the embodiments described above. In addition, some parts of individual modules functionally integrated in a single module may be included in the display device, while other parts may be provided separately from the display device. For example, the display device may include the display module 11, whereas the processor 12, memory 13 and power module 14 may be provided as parts of another device within the electronic device 10 rather than the display device.

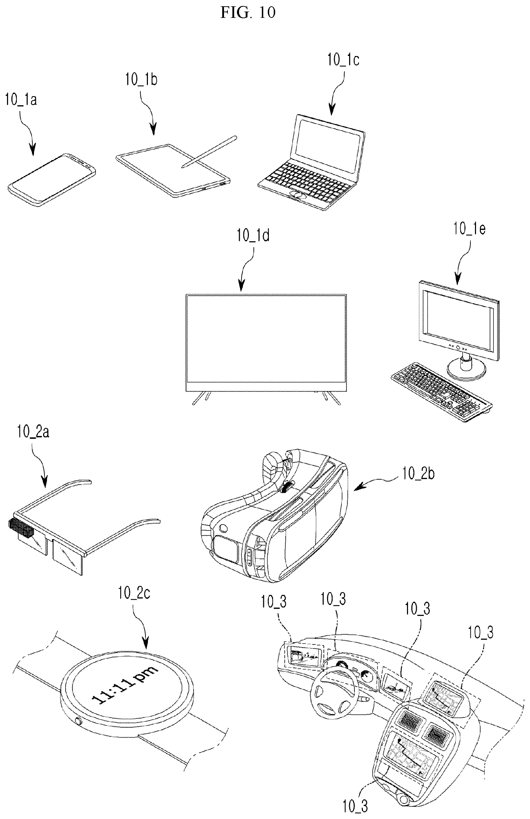

FIG. 10 is a set of schematic views illustrating electronic devices according to various embodiments.

Referring to FIG. 10, various electronic devices to which the display device according to the above-described embodiments is applied may include not only image display electronic devices such as a smartphone 10_1a, a tablet PC 10_1b, a laptop 10_1c, a TV 10_1d, a desktop monitor 10_1e, etc., but also wearable electronic devices including a display module such as smart glasses 10_2a, a head-mounted display 10_2b, a smart watch 10_2c, etc., and vehicle electronic devices 10_3 including display modules such as a center information display (CID) arranged on an instrument panel, center fascia, or dashboard of a vehicle, and a room mirror display. Further, the electronic device may also include virtual reality glasses, or augmented reality glasses.

According to an embodiment of the present disclosure, an auxiliary conductive layer and an auxiliary electrode may be formed on the upper portion of the cathode to improve a drop (or a reduction) in internal resistance (e.g., resistance of a pixel's cathode electrode). Thereby, the quality (e.g., image quality) and/or reliability of the display device may be improved. For example, the long-range uniformity (LRU) of the display device may be improved, noise in the touch screen panel (TSP) may be reduced, power consumption may be decreased, and light extraction efficiency may be enhanced.

According to an embodiment of the present disclosure, the auxiliary conductive layer and/or the auxiliary electrode may extend to the outer periphery (non-display area) of the display device, thereby improving the encapsulation performance (e.g., preventing permeation of oxygen, moisture, etc.).

Various embodiments of the present disclosure and the terms used herein do not limit the technical characteristics described in the present disclosure to specific embodiments, but should be interpreted to include various modifications, equivalents, or substitutions of the embodiments. With regard to the description of the drawings, similar or related components may be denoted by similar reference numerals. It is to be understood that a singular form of a noun corresponding to an item may include one or a plurality of the items, unless the relevant context clearly indicates otherwise. As used herein, each of phrases such as "A or B," "at least one of A and B," "at least one of A or B," "A, B or C," "at least one of A, B and C," and "at least one of A, B or C" may include any one, or all possible combinations of these items enumerated together in the corresponding one of the phrases. As used herein, the terms such as "1st" and "2nd," or "first" and "second" may be used to simply distinguish the corresponding component from another component, and do not limit the corresponding components in other aspects (e.g., an importance or order). It is to be understood that if a component (e.g., a first component) is referred to as "coupled to" or "connected to" another component (e.g., a second component), with or without the term "operatively" or "communicatively," it means that the component may be connected to the other component directly (e.g., by wire), wirelessly, or via a third component.

The term "module" used in various embodiments of the present disclosure may include a unit implemented in hardware, software or firmware way, and for example, may be used interchangeably with the terms such as logic, a logic block, a part, or a circuit. The module may be a part integrally formed therewith, or a minimum unit of the part or a portion thereof which performs one or more functions. For example, according to an embodiment, the module may be implemented in the form of an application-specific integrated circuit (ASIC).

Various embodiments of the present disclosure may be implemented by software (e.g., a program) including one or more instructions stored in a storage medium (e.g., an internal memory or an external memory) readable by a machine (e.g., the electronic device 10). For example, a processor of the machine (e.g., the electronic device 10) may call, among one or more instructions stored in the storage medium, at least one instruction, and may execute the instruction. This allows at least one function to be performed according to the called at least one instruction. The one or more instructions may include a code that is made by a compiler or a code that may be executed by an interpreter. The storage medium that may be read by a device may be provided in a form of a non-transitory storage medium. Here, the 'non-transitory storage medium' means that the storage medium is a tangible device and does not include a signal (e.g., an electromagnetic wave), and with regard to the term, a case, in which data are semi-permanently stored in the storage medium, and a case, in which data are temporarily stored in the storage medium, are not distinguished.

According to various embodiments, each component or element (e.g., a module or program) of the above-described components or elements may include one or a plurality of entities, and some of the plurality of entities may be disposed to other components with being separated therefrom. According to various embodiments, among the above-described components, one or more components or operations thereof may be omitted or one or more other components or operations thereof may be added to the components. In an embodiment, the plurality of components (e.g., the modules or programs) may be integrated into one component. In this case, the integrated components may perform one or more functions of each component of the plurality of components in a way that they are the same as or similar to the functions performed by the corresponding components among the plurality of components before the integration. According to various embodiments, operations performed by the modules, programs, or other components may be executed sequentially, in parallel, repeatedly, or heuristically, one or more operations may be executed in another sequence or omitted, or one or more other operations may be added thereto.

## Claims

1. A display device (100, 500, 600, 700, 800) comprising:
a substrate (310);
a driving element layer (320) on the substrate (310) and comprising a driving element configured to drive a display panel (110), a first electrode of a pixel, and a pixel defining layer (323) configured to define an opening on a portion of the first electrode;
a light-emitting layer (330) in the opening;
a second electrode (340, 840) on the light-emitting layer (330) and the pixel defining layer (323);
an auxiliary conductive layer (350, 550, 650, 750, 850) on the second electrode (340, 840);
an auxiliary electrode (360, 560, 660, 760, 860) on the auxiliary conductive layer (350, 550, 650, 750, 850); and
an encapsulation layer (370) on the auxiliary electrode (360, 560, 660, 760, 860).

2. The display device (100, 500, 600, 700, 800) according to claim 1, wherein the display panel (110) comprises a display area (DA) in which an image is displayed and a non-display area (NDA) in which no image is displayed and which is located at an outer periphery of the display panel (110), and
the auxiliary electrode (360, 560, 660, 760, 860) and the auxiliary conductive layer (350, 550, 650, 750, 850) extend to the non-display area (NDA).

3. The display device (100, 500, 600, 700, 800) according to claim 2, wherein the auxiliary electrode (360, 560, 660, 760, 860) extends up to a protective area (326) in the non-display area (NDA).

4. The display device (100, 500, 600, 700, 800) according to claim 2, wherein the auxiliary electrode (360, 560, 660, 760, 860) extends beyond a protective area (326) in the non-display area (NDA) and one end of the auxiliary electrode (360, 560, 660, 760, 860) is positioned between the auxiliary conductive layer (350, 550, 650, 750, 850) and the protective area (326) in a first direction and a second direction crossing to the first direction.

5. The display device (100, 500, 600, 700, 800) according to claim 2, wherein the auxiliary electrode (360, 560, 660, 760, 860) extends beyond a protective area (326) in the non-display area (NDA) and one end of the auxiliary electrode (360, 560, 660, 760, 860) is positioned between the encapsulation layer (370) and the auxiliary conductive layer (350, 550, 650, 750, 850) in a first direction and a second direction crossing to the first direction.

6. The display device (100, 500, 600, 700, 800) according to claim 2, wherein the auxiliary electrode (360, 560, 660, 760, 860) completely covers the auxiliary conductive layer (350, 550, 650, 750, 850) and one end of the auxiliary electrode (360, 560, 660, 760, 860) is exposed to the outside.

7. The display device (500) according to any one of claims 1 to 6, wherein at least one of the auxiliary conductive layer (550) and the auxiliary electrode (560) comprises a plurality of layers.

8. The display device (100, 500, 600, 700, 800) according to any one of claims 1 to 7, wherein the auxiliary conductive layer (350, 550, 650, 750, 850) is configured to improve protective characteristics, and
the auxiliary electrode (360, 560, 660, 760, 860) is configured to improve at least one of resistance characteristics, adhesion characteristics, and optical characteristics.

9. The display device (600, 700) according to any one of claims 1 to 8, further comprising an auxiliary protective layer (680, 780) positioned between the auxiliary conductive layer (650, 750) and the encapsulation layer (370) to assist in enhancing protective characteristics of the auxiliary conductive layer (650, 750).

10. The display device (700) according to claim 9, wherein the auxiliary protective layer (780) is formed in a multi-layer structure.

11. The display device (100, 500, 600, 700, 800) according to any one of claims 1 to 10, wherein the auxiliary electrode (360, 560, 660, 760, 860) is in direct contact with the auxiliary conductive layer (350, 550, 650, 750, 850) or is electrically connected thereto through a contact hole in the auxiliary conductive layer (350, 550, 650, 750, 850).

12. The display device (100, 500, 600, 700, 800) according to any one of claims 1 to 11, further comprising an optical characteristic adjustment layer positioned between the second electrode (340, 840) and the auxiliary conductive layer (350, 550, 650, 750, 850).

13. The display device (100, 500, 600, 700, 800) according to claim 12, wherein the optical characteristic adjustment layer comprises a capping layer or a lithium fluoride (LiF) layer.

14. The display device (100, 500, 600, 700, 800) according to any one of claims 1 to 13, further comprising a touch electrode on the encapsulation layer (370).

15. An electronic device (10) comprising:
a display device (100, 500, 600, 700, 800);
a memory (13) configured to store data for operation of the display device (100); and
one or more processors (12) configured to execute the data stored in the memory (14) to control the operation of the display device (100),
wherein the display device (100, 500, 600, 700, 800) is a display device (100, 500, 600, 700, 800) according to any one of claims 1 to 14.
